(19) Europäisches Patentamt
European Patent Office
Office européen des brevets

(11) **EP 4 350 750 A1**

(12) **EUROPEAN PATENT APPLICATION**

(43) Date of publication:
**10.04.2024 Bulletin 2024/15**

(51) International Patent Classification (IPC):
**H01L 21/683** (2006.01)

(21) Application number: **22199670.5**

(22) Date of filing: **04.10.2022**

(52) Cooperative Patent Classification (CPC):
**H01L 21/6835;** H01L 2221/68327; H01L 2221/6834;
H01L 2221/68381

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Imec VZW**
**3001 Leuven (BE)**

(72) Inventors:
• **VISKER, Jakob**
**3020 Herent (BE)**
• **PENG, Lan**
**3001 Leuven (BE)**
• **VANHAELEMEERSCH, Serge**
**3001 Leuven (BE)**
• **HUMBERT, Aurelie**
**1030 Schaarbeek (BE)**
• **DANG THI THUY, Chi**
**3001 Leuven (BE)**
• **VISKER, Evert**
**3000 Leuven (BE)**

(54) **A PROCESS FOR WAFER BONDING**

(57) The present invention relates to a temporary wafer bonding process comprising the steps of: providing a wafer (1) for back processing by laminating a plain protective film (2) on a front surface (1a) of the wafer; providing a rigid carrier (3); bonding the rigid carrier to the plain protective film by the intermediate of a bonding material layer; processing a back surface (1b) of the wafer; and separating the rigid carrier and the plain protective film from the wafer.

Fig. 1

EP 4 350 750 A1

**Description**

Technical field

The present invention is generally related to a process for wafer bonding in semiconductor processing and more specifically to a process for temporary wafer bonding for back processing.

Technical background

Temporary wafer bonding refers to a process where a wafer is temporarily bonded to a rigid carrier with "temporary bonding material" and, later on, the rigid carrier is separated or de-bonded from the wafer. Temporary wafer bonding is an important step of the manufacturing of semiconductor devices. An adhesive temporary bonding material is often used for the bonding process.

A known technique for temporary wafer bonding using an adhesive temporary bonding material is explained in document "Development of Micrometer-Thick Bonding Material for Wafer-On-Wafer (WOW) Applications" by N. Araki et al., 2018 13th International Microsystems, Packaging, Assembly and Circuits Technology Conference (IMPACT), 2018, pp. 214-217.

Using an adhesive temporary bonding material leaves glue residues on the wafer after debonding. To remove the residues, rinsing with an aggressive chemical is required. However, the rinsing chemical can damage the front surface of the wafer, especially if it is thin and/or structured. Therefore, there is a need in the art to overcome at least partly this issue.

Summary of the invention

The invention is set out in the appended set of claims.

It is an objective of the invention to at least partly overcome the limitations of the prior art. As an example, it is an object to provide a process for efficiently preventing glue residue on the wafer as a result of a temporary wafer bonding process.

According to the present description, a process for temporary wafer bonding comprises:

a. providing a wafer for back processing by
a.1 laminating a plain protective film on a front surface of the wafer.
b. providing a rigid carrier.
c. bonding the rigid carrier to the plain protective film by the intermediate of a bonding material layer.
d. processing a back surface of the wafer.
e. separating the rigid carrier and the plain protective film from the wafer.

It is an advantage of embodiments of the present description that they prevent partly or completely the presence of the residue from the bonding material layer, such as glue residue, on the front surface of the wafer after the rigid carrier and the plain protective film are completely separated from the wafer. It also protects the structures on the front surface from the mechanical stress induced by the bonding process. Therefore, the device performance and yield are not affected by the temporary wafer bonding. Conventional temporary bonding processes coat the bonding material on the rigid carrier by, for example, spin coating. The wafer is bonded to the rigid carrier where the bonding material directly contacts the front surface of the wafer. In the present description, the bonding material can be coated on the rigid carrier and the wafer is bonded to the rigid carrier where the bonding material contacts the plain protective film. At least part of the bonding material can be alternatively coated directly on the plain protective film. Therefore, the bonding material has no contact with the front surface of the wafer, especially when the bonding material comprises a glue layer. It is an advantage of embodiments of the present description that they are compatible with standard CMOS materials and applicable for a wide range of devices.

According to an example embodiment, the process is for temporary wafer bonding in fabrication of Micro-Electro-Mechanical Systems (MEMS).

According to an example embodiment, the step (e) of separating the rigid carrier and the plain protective film from the wafer comprises:

e.1. separating the rigid carrier from the plain protective film; followed by
e.2. removing the plain protective film from the front surface of the wafer.

It is an advantage of this embodiment that it consumes limited amount of chemicals to remove the plain protective film. This step order gives an easy chemical access to the plain protective film.

According to an example embodiment, the step e of separating the rigid carrier and the plain protective film from the wafer comprises a wet etching step before the step (e.2) of removing the plain protective film from the front surface of the wafer. It is an advantage because the front surface of the wafer is protected during the wet etching step.

According to an example embodiment, the step e of separating the rigid carrier and the plain protective film from the wafer comprises a step of wet etching the bonding material layer after step (e.1) of separating the rigid carrier from the plain protective film and before the step (e.2) of removing the plain protective film from the front surface of the wafer. It is an advantage because the front surface of the wafer is protected during the wet etching of at least part of the bonding material layer.

According to an example embodiment, the step (e) of separating the rigid carrier and the plain protective film from the wafer comprises a step of wet etching glue residues on the plain protective film after step (e.1) of separating the rigid carrier from the plain protective film. It is an advantage because the front surface of the wafer is protected during the wet etching of the glue residues from the bonding material layer. It is also an advantage because the complete removal of the bonding material layer allows controllable removal of the plain protective film from the front surface of the wafer.

According to an example embodiment, the step (e) of separating the rigid carrier and the plain protective film from the wafer comprises wet etching the plain protective film. It is an advantage that the laminated plain protective film can be removed with controlled amount of chemicals so that the exposure time of the front surface of the wafer to the chemicals is limited. The front surface of the wafer has a limited contact time with etching chemicals. This prevents damages to fragile structures exposed to the etching chemicals. The potential damage of the front surface of the wafer from the chemicals is also limited.

According to an example embodiment, the step (d) of processing a back surface of the wafer comprises a heating step of the back surface above 150 °C. According to an example embodiment, the step (d) of processing a back surface of the wafer comprises a heating step of the back surface above 300 °C. It is an advantage that the process is compatible with complex back processing steps. In the processes comprising a heating step, they further prevent glue contamination from glue bubbling at high temperatures.

According to an example embodiment, the wafer is a semiconductor substrate, optionally comprising CMOS circuitry. It is an advantage that they are compatible with CMOS fabrication steps performed on the wafer before, during, or after the process.

According to an example embodiment, the rigid carrier is transparent.

It is an advantage of using a rigid carrier that it provides mechanical stability during the bonding process. It protects the wafer from mechanical stress induced by the bonding process and further prevents or reduces cracks on or in the wafer during the process. The rigid carrier provides physical support during back processing. It is an advantage of using a transparent rigid carrier that it enables visibility of optical alignment marks, such as optical alignment marks for hardmask alignment, through the transparent carrier.

According to an example embodiment, the rigid carrier is a glass carrier. It is an advantage that a glass carrier is compatible with CMOS fabrication processes.

According to an example embodiment, the front surface of the wafer comprises a cavity, optionally extending to the back surface, before the step (a.1) of laminating a plain protective film on a front surface of the wafer. It is an advantage that they are compatible with a complex topography of the front surface of the wafer, such as protrusions and/or cavities. Contrary to a conventional spin-on coating of an adhesive bonding material directly on a wafer, or other analog deposition methods, especially when applied on a complex topography with cavities, the laminated plain protective film used is mostly attached to the front surface of the wafer and does not substantively flow into device features such as cavities.

According to an example embodiment, the cavity has an aspect ratio of at least 1. According to an example embodiment, the cavity has an aspect ratio of at least 2. It is an advantage of the process that it prevents glue contamination inside any cavity at the front surface of the wafer, especially deep cavities.

According to an example embodiment, the wafer in the step (a) of providing a wafer (1) for back processing comprises a stack of layers.

According to an example embodiment, the wafer in the step (a) of providing a wafer (1) for back processing comprises a stack of layers, wherein at least one layer is formed by wafer bonding. More specifically, the at least one layer is formed by (sub-)wafer-to-(sub-)wafer bonding. It is an advantage of the process that it is compatible with complex processing steps prior to bonding. It is an advantage of some embodiments of the present description that a stack of layers can be bonded, thereby forming a wafer, prior to the temporary bonding process.

According to an example embodiment, the plain protective film comprises a polymer, preferably having a glass transition temperature below 100°C. It is an advantage that the properties of the plain protective film allow cost-effective lamination.

According to an example embodiment, the plain protective film either is glue-free or comprises a glue layer of thickness thinner than 5nm on the surface of the plain protective film that will contact the front surface of the wafer during step (a.1) of laminating a plain protective film on a front surface of the wafer. It is an advantage that the plain protective film is not glued to the front surface of the wafer and instead is attached to the front surface by lamination. Therefore, no glue residue is left on the front surface when using a glue-free plain protective film. Even when the plain protective film comprises a glue layer of thickness thinner than 5nm, the glue residues left on the front surface of the wafer are very limited.

According to an example embodiment, the bonding material layer comprises a photosensitive material. It is an advantage that the bonding material layer can be removed from the plain protective film by exposing the bonding material layer to light.

According to an example embodiment, the step (e) of separating the rigid carrier and the plain protective film from the wafer comprises a step of exposing the bonding material layer to UV light. It is an advantage that the process is compatible with conventional debonding methods.

According to an example embodiment, the step (a.1) of laminating a plain protective film on a front surface of a wafer is performed at a temperature above 85°C and a pressure above 103 kPa. It is an advantage that the plain protective film can be particularly efficiently laminated on the front surface of the wafer.

Brief description of the drawings

**Figure 1** is a flowchart showing the steps of example processes according to the present description.

**Figures 2a to 2e** show an example schematic illustration of a series of vertical cross sections through intermediate structures obtained during steps of the process flowchart of figure 1.

**Figures 3a to 3c** show an example schematic illustration of a vertical cross sections through different exemplary cavities in the wafer.

**Figures 4a to 4e** show a second example schematic illustration of a series of vertical cross sections through intermediate structures obtained during steps of the process flowchart of figure 1.

**Figures 5a to 5e** show a third example schematic illustration of a series of vertical cross sections through intermediate structures obtained during steps of the process flowchart of figure 1.

**Figures 6a and 6b** show pictures of wafers after conventional temporary bonding processes.

**Figure 6c** shows an example picture of a wafer after a process according to the present description.

Detailed description

The disclosure will be further elucidated by means of the following description and the appended figures. Various exemplary embodiments are described herein with reference to the following figures, wherein like numeral denotes like entities. The figures described are schematic and are non-limiting. Further, any reference signs in the claims shall not be construed as limiting the scope of the present disclosure. Still further, in the different figures, the same reference signs refer to the same or analogous elements.

The terms "over" and "above" are used for position indication of layers and not necessarily for describing a direct contact of the layers. It is to be understood that the terms so used are interchangeable under appropriate circumstances. The term "on" is used for position indication of layers and describing a direct contact of the layers.

The term "comprising", used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. The term "comprising" therefore covers the situation where only the stated features are present (and can therefore always be replaced by "consisting of" in order to restrict the scope to said stated features) and the situation where these features and one or more other features are present. The scope of the expression "a device comprising means A and B" should therefore not be interpreted as being limited to devices consisting only of components A and B. It may mean that the only relevant components of the device are A and B.

The term "a" shall be interpreted as a function word before a mass noun to denote a particular type or instance. It should not be interpreted as a function word before a singular noun referring one object.

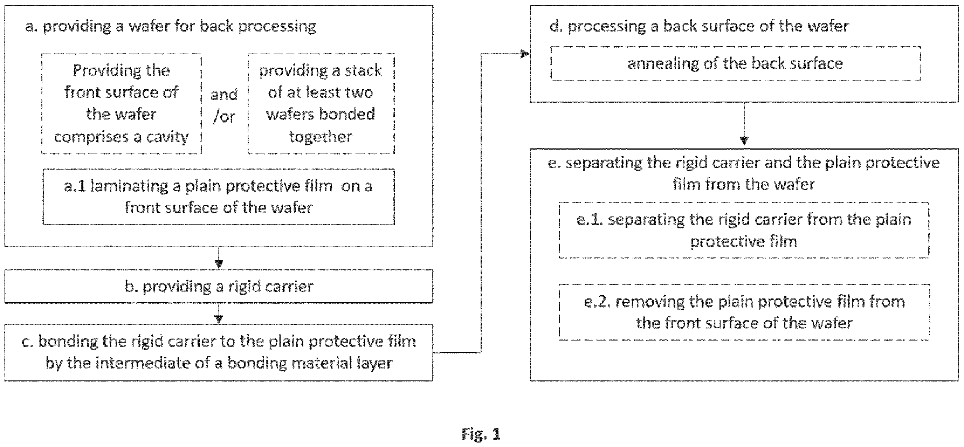

As shown in figure 1, the present description relates to a process for temporary wafer bonding, comprising steps of

a. providing a wafer for back processing by
a.1 laminating a plain protective film on a front surface of the wafer;
b. providing a rigid carrier;
c. bonding the rigid carrier to the plain protective film by the intermediate of a bonding material layer;
d. processing a back surface of the wafer;
e. separating the rigid carrier and the plain protective film from the wafer.

In the field of semiconductor manufacturing, the term "wafer" can take two meanings. In a first definition, a wafer is a slice of semiconductor (such as silicon or germanium) used as a base for an electronic component or circuit. In that definition, a wafer is a one-piece semiconductor structure. The term wafer is, however, also frequently used in the semiconductor manufacturing industry to group together wafers according to the first definition as well as semiconductor structures comprising a wafer according to the first definition. For instance, such semiconductor structures may comprise the following elements in addition to the wafer according to the first definition:

- one or more further wafers according to the first definition (i.e., sub-wafers), and/or

- one or more layers (e.g., semiconductor layers, bonding material layers, bonded layers,...), and/or

- electronic circuitry.

In the present description, this second definition is used and wafers according to the first definition will generally be referred to as sub-wafers.

In embodiments, the wafer can comprise a silicon or germanium substrate. It can further comprise one or more layers of semiconductor materials, such as one or more silicon layers (e.g., sub-wafers) or one or more germanium layers (e.g., sub-wafers). In typical examples, the wafer may comprise a silicon substrate and one or more additional silicon layers. In another typical examples, the wafer may comprise a germanium substrate and one or more additional germanium layers. For instance, the wafer may comprise a semiconductor substrate and the one or more layers of semiconductor materials may comprise a further semiconductor substrate. In such embodiments, the wafer may comprise two or more semiconductor substrates bonded together, e.g., by wafer bonding.

Wafer bonding refers to a thermo-compression bonding process by which a wafer and a substrate of any material adhere to each other. The process involves the application of a gluing layer. Temporary wafer bonding refers to a process where a wafer is temporarily adhered or bonded to a rigid carrier with a bonding material and later on the rigid carrier is separated or de-bonded from the wafer. Bonding material refers to a group of polymeric bonding materials which forms at least an adhesive layer between the wafer and the substrate.

The term "front surface" and "back surface" are used as references for certain surfaces of the wafer. It is to be understood that the "front surface" can appear as a bottom surface in figures under appropriate circumstances, for example when the wafer is turned around. And "back surface" is the surface of the wafer at the opposite from the "front surface". The "front surface" and the "back surface" are typically substantially in parallel planes.

The term "laminating" or "lamination" refers to a process of pressing a layer of dry film on the wafer by pressing and rotating at least one roller on the dry film. The lamination step is often followed by a baking step at a temperature, e.g., above 30°C.

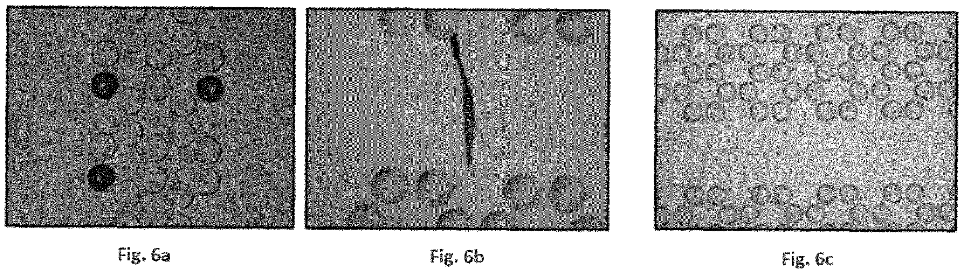

As shown in figure 6c, the structure and yield of the wafer after step (e) of separating the rigid carrier and the plain protective film from the wafer are not affected by the temporary wafer bonding. The process in the present description avoids residues of the bonding material on the wafer, as shown in figure 6a, after debonding. The process in the present description avoids cracks, as shown in figure 6b, on the front surface of the wafer during the process.

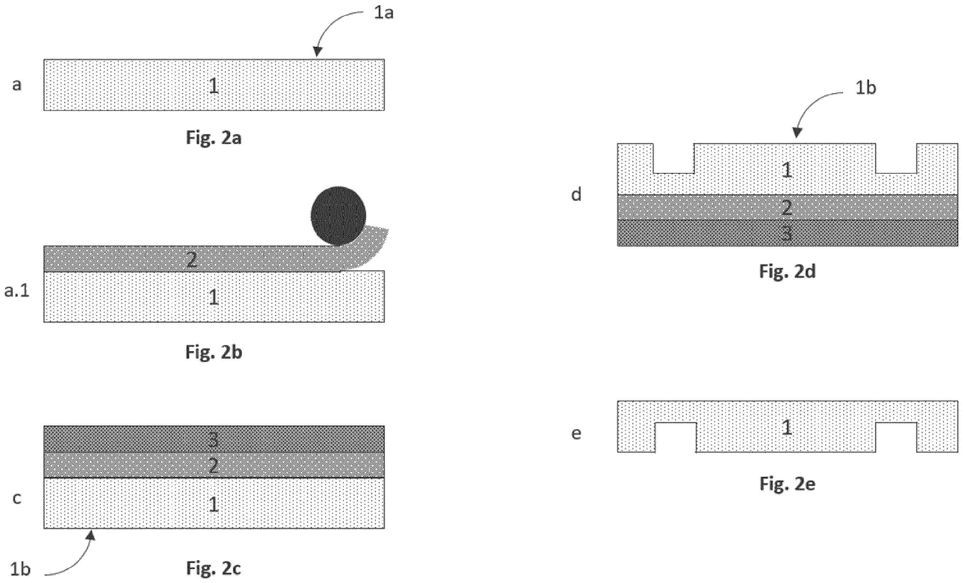

We now refer to figures 2a to 2e. According to an example embodiment, the step (a.1) of laminating a plain protective film 2 on a front surface 1a of a wafer 1 is performed at a temperature above 85°C and a pressure above 103 kPa. According to an example embodiment, the lamination temperature is from 85 to 110°C, for example at 95°C. According to an example embodiment, the step (a.1) of laminating a plain protective film 2 on a front surface 1a of a wafer 1 is followed by a post baking at a temperature of from 150 to 300°C. According to an example embodiment, the post baking lasts from 4 to 10 hours. Typically, the product of the post baking temperature (°C) and the post baking duration (hours) is from 1000 to 1800 °C*hours, preferably from 1200 to 1600 °C*hours. According to an example embodiment, the post baking is at a temperature of 150°C and lasts for 10 hours. According to an example embodiment, the post baking is at a temperature of 200°C and lasts for 8 hours. According to an example embodiment, the post baking is at a temperature of 250°C and lasts for 6 hours. According to an example embodiment, the post baking is at a temperature of 300°C and lasts for 4 hours.

The term "plain protective film", used in the claims, should be interpreted as being a continuous film which is not being patterned, for example, by lithographic procedures. The plain protective film covers at least 90 percent and preferably completely the front surface of the wafer.

According to an example embodiment, the plain protective film 2 is obtained away from a front surface 1a of the wafer 1 before performing step (a.1) of laminating a plain protective film on a front surface of the wafer. According to an example embodiment, the plain protective film is provided as a roll of the film.

According to an example embodiment, step (a.1) of laminating a plain protective film 2 on a front surface 1a of the wafer 1 is directly followed by step (c) of bonding the provided rigid carrier 3 to the plain protective film 2 by the intermediate of a bonding material layer (not shown in the figures).

According to an example embodiment, the plain protective film 2 comprises a polymer. According to an example embodiment, the plain protective film 2 has a glass transition temperature below 100°C. During lamination, the plain protective film 2 may be rolled on the front surface 1a of the wafer at a temperature at least equal to the glass transition temperature such that the plain protective film 2 becomes more flexible and attach to the front surface 1a of the wafer 1.

According to an example embodiment, the plain protective film 2 comprises 3 layers: a base layer, a core layer, and a cover layer. According to an example embodiment, the base layer comprises a polyester film. The thickness of the base layer is between 15 to 25 μm. According to an example embodiment, the core layer comprises monomer include a compound having one or more $\alpha,\beta$-ethylenic unsaturated bonds. According to an example embodiment, the compound has two or more acryloyl groups or methacryloyl group in the molecule. According to an example embodiment, the core layer comprises a binder polymer providing mechanical strength, tenting property and adhesiveness of a photopolymerization composition. According to an example embodiment, the core layer comprises some additives such as dyes, stabilizers, adhesion promoter or thermal polymerization inhibitor. The core layer has the thickness ranging from 15 to 100 μm. According to an example embodiment, the cover layer is a polyolefin film. The cover layer has a thickness ranging from 25 to 30 μm. The base layer is employed as a supporter, while the cover layer serves to prevent a damage of the core layer by dusts and handling thereof. According to an example embodiment, the plain protective film 2 comprises a photosensitive compound. According to an example, the plain protective film 2 comprises a photoresist layer.

According to an example embodiment, the plain protective film 2 has a thickness of from 55 to 155 μm.

According to an example embodiment, the plain protective film 2 is glue-free. The glue-free plain protective film 2 advantageously avoids glue contamination on the front surface 1a of the wafer 1. According to an example embodiment, the plain protective film 2 comprises a glue layer having a thickness below 5nm on the surface of the plain protective film that will contact the front surface 1a of the wafer during step (a.1) of laminating a plain protective film on a front surface of the wafer.

According to an example embodiment, the rigid carrier 3 is transparent such that UV light can be transmitted through it.

According to an example embodiment, the rigid carrier 3 is a glass carrier. According to another example embodiment, the rigid carrier 3 is a semiconductor carrier.

In step (c), the rigid carrier is bounded to the plain protective film by the intermediary of the bonding material layer. According to an example embodiment, the bonding material layer is bounded on the plain protective film, and then, the rigid carrier is bounded on the bonding material layer such that the bonding material is in between the plain protective film and the rigid carrier. According to another example embodiment, the bonding material layer is applied to the rigid carrier, and then, the rigid carrier is bounded on the wafer such that the bonding material is in between the plain protective film and the rigid carrier.

According to an example embodiment, the bonding material layer comprises a glue layer. According to an example embodiment, the glue layer has a thickness between 5 to 200um.

According to an example embodiment, the bonding material layer comprises at least a layer of photosensitive material, i.e., a photosensitive layer. The photosensitive layer can be a polymer layer. According to an example embodiment, the bonding material layer has a thickness between 20 nm to 200 μm.

According to an example embodiment, the step (e) of separating the rigid carrier 3 and the plain protective film 2 from the wafer 1 comprises a step of mechanical debonding.

According to an example embodiment, the step (e) of separating the rigid carrier 3 and the plain protective film 2 from the wafer 1 comprises a step of exposing the wafer 1 to UV light. The UV exposure will change the chemical properties of the photosensitive bonding material layer to de-bond the rigid carrier 3. According to an example embodiment, the glue layer is wet etched from the plain protective film 2. According to another example embodiment, the glue layer is peeled away from the plain protective film 2.

According to an example embodiment, the step e of separating the rigid carrier 3 and the plain protective film 2 from the wafer 1 comprises two steps:

e.1. separating the rigid carrier 3 from the plain protective film 2; and
e.2. removing the plain protective film 2 from the front surface 1a of the wafer 1.

According to an example embodiment, the step (e.1). separating the rigid carrier 3 from the plain protective film 2 is followed by step (e.2). removing the plain protective film 2 from the front surface 1a of the wafer 1. According to an example embodiment, step (e.1) separates the rigid carrier and at least part of the bonding material layer from the plain protective film.

According to an example embodiment, the step (e.1). of separating the rigid carrier 3 from the plain protective film 2 is directly followed by step (e.2). removing the plain protective film 2 from the front surface 1a of the wafer 1.

The term "wet etching" refers to a material removal process that uses liquid chemicals to remove materials from a wafer. The term is interchangeable with the term "wet stripping" or "wet removing".

According to an example embodiment, the step e of separating the rigid carrier 3 and the plain protective film 2 from the wafer 1 comprises wet etching the plain protective film 2.

According to an example embodiment, the plain protective film 2 is removed completely with wet etching or wet stripping.

Back processing refers to processing at the surface of the wafer opposed to the surface of the wafer which is bonded to the rigid carrier. The term "backside processing" or "processing the back surface" can be used as alternatives in the same context.

According to an example embodiment, the step (d) of processing a back surface 1b of the wafer 1 comprises a heating step of the back surface 1b above 150°C. According to an example embodiment, the step (d) of processing a back surface 1b of the wafer 1 comprises a heating step of the back surface 1b above 300°C. According to an example embodiment, the step (d) of processing a back surface 1b of the wafer 1 comprises backside thinning, which could be also referred as backgrinding. The backside thinning reduces the thickness of the wafer by removing material from the back surface of the wafer. According to an example embodiment, the step (d) of processing a back surface 1b of the wafer 1 comprises deposition, dry etching, wet etching, plating, and/or cleaning.

In figure 2a, wafer 1 is provided. According to an example embodiment, wafer 1 is cleaned with a light acid solution (2-3% by volume sulfuric acid solution) followed by a D.I. (Deionized water) water rinse and by a drying with nitrogen gas. The front surface 1a is then substantially free of any kind of organic contamination and metal oxides from previous processes.

In figure 2b, the plain protective film 2 is laminated on the front surface 1a of the wafer 1. The temperature and pressure are applied by a hot roll during the lamination process to make the plain protective film 2 more flexible and eliminate any air entrapment between the front surface 1a of the wafer 1 and the plain protective film 2. According to an example embodiment, the roll speed is between 0.6 to 1.5 m/min. According to an example embodiment, the wafer 1 is cooled down to room temperature after lamination. According to an example embodiment, a post lamination bake is used to further promote polymer film attachment.

In figure 2c, a layer of temporary bonding material (not shown in the figure) is applied on the plain protective film 2. A rigid carrier 3 is bonded to the plain protective film 2 by the intermediate of the adhesive temporary bonding material layer. The temporary bonding material is not in contact with the front surface 1a of the wafer 1. During any steps of the processing, including the post baking of the lamination process or any later heating process, the adhesive temporary bonding material layer does not form any intimate contact with the wafer 1. Therefore, no contamination of the wafer by the temporary bonding material layer occurs during the whole process.

In figure 2d, the wafer 1 is flipped over so that the back surface 1b can be easily processed.

In figure 2e, the wafer 1 is flipped over again so that the rigid carrier 3 and the plain protective film can be more easily removed from the front surface 1a of the wafer 1.

According to an example embodiment, the wafer 1 comprises a cavity before the step (a.1) of laminating a plain protective film 2 on a front surface 1a of a wafer 1.

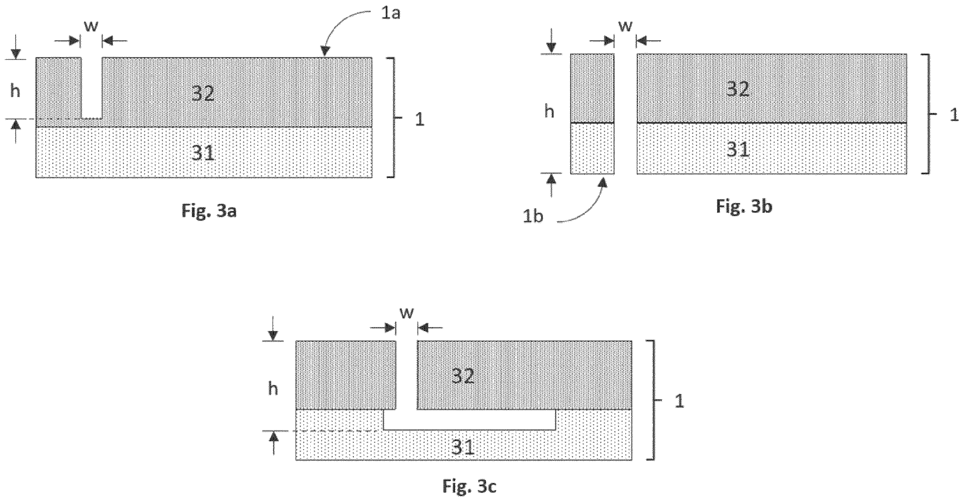

According to an example embodiment, the front surface 1a of the wafer 1 comprises a cavity. According to an example embodiment, as shown in figure 3a, the cavity extends vertically from the front surface 1a of the wafer 1. According to an example embodiment, as shown in figure 3b, the cavity extends vertically from the front surface 1a to the back surface 1b of the wafer 1. According to an example embodiment, as shown in figure 3c, the cavity extends vertically from the front surface 1a of the wafer 1 and fluidically connects with a cavity extending horizontally within the wafer 1.

According to an example embodiment, the cavity has an aspect ratio of at least 1, preferably more than 2. The aspect ratio of a cavity is calculated as the longest vertical extent, i.e., the height h, versus the longest horizontal extent, i.e., the width w, measured at the front surface 1a.

$$AR = h/w$$

According to an example embodiment, the wafer 1 in the step (a) of providing a wafer 1 for back processing, comprises providing a stack of layers 31, 32, 41, 42, 51, 52.

According to an example embodiment, the wafer 1 in the step (a) of providing a wafer 1 for back processing, comprises providing a stack of layers 31, 32, 41, 42, 51, 52, wherein at least one of the layers is formed by wafer bonding. According to an example embodiment, the wafer bonding is a wafer-to-wafer bonding. Wafer-to-wafer bonding is a process for temporary or permanent joining of two or more sub-wafers with or without an intermediate layer. The wafer 1 provided in the step (a) of providing a wafer (1) for back processing may refer to a wafer already formed by wafer-to-wafer bonding of the sub-wafers. According to an example embodiment, the layers were sub-wafers wherein the sub-wafers are wafers to be bonded together to form a new wafer. According to an example embodiment, the layers 31, 32, 41, 42, 51, 52 or sub-wafers may have been processed before bonding to form wafer 1. According to an example embodiment, a cavity is formed on a surface of the layer 32, 42.

According to an example embodiment, when the contact surface of the two sub-wafers is constituted with substantively same material, one layer can be formed from the wafer-to-wafer bonding.

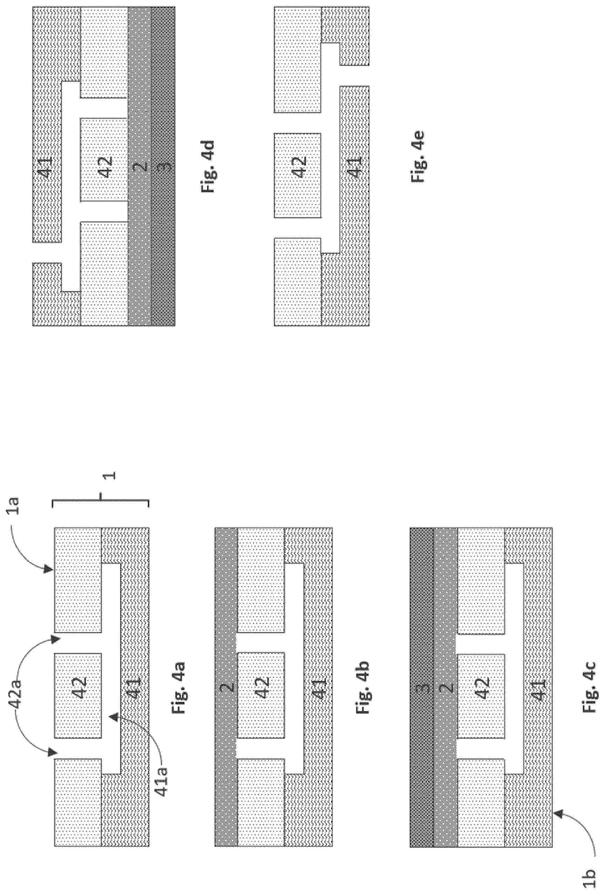

Wafer 1 comprises a stack of layers 41 and 42. The layers 41 and 42 can be different sub-wafers. The wafer 1 can be formed of layer 41 (e.g., a sub-wafer) and 42 (e.g., a different sub-wafer) by wafer bonding before the step (a.1) of laminating a plain protective film 2 on a front surface 1a of a wafer 1. In figure 4a, cavity 41a is formed on the layer 41. The cavities 42a are formed on the layer 42 after bonding and extend from the front surface 1a of the wafer 1 to the cavity 41a. According to an example embodiment, the layer 41 and/or 42 can be thinned before bonding.

In figure 4b, the plain protective film 2 is laminated on the front surface 1a of the wafer 1. The temperature and pressure applied during the lamination process make the plain protective film 2 more flexible and eliminate any air entrapment between the wafer 1 and the plain protective film 2.

In figure 4c, a layer of temporary bonding material (not shown in the figure) is applied on the plain protective film 2. A rigid carrier 3 is bonded to the plain protective film 2 by the intermediate of the adhesive temporary bonding material layer. The temporary bonding material is not contacting the front surface 1a of the wafer 1. During any steps of the processing, including the post baking of the lamination process or any later heating process, the adhesive temporary bonding material layer does not form any intimate contact with the wafer 1. Therefore, no contamination of the wafer by the temporary bonding material layer occurs during the whole process.

In figure 4d, the wafer 1 is flipped over so that the back surface 1b can be easily processed. A cavity is formed from the back surface 1b of the wafer 1 and extended to the horizontal cavity 41a. According to an example embodiment, the wafer 41 can be thinned before the cavity is formed.

In figure 4e, the wafer 1 is flipped over again so that the rigid carrier 3 and the plain protective film can be more easily removed from the front surface 1a of the wafer 1.

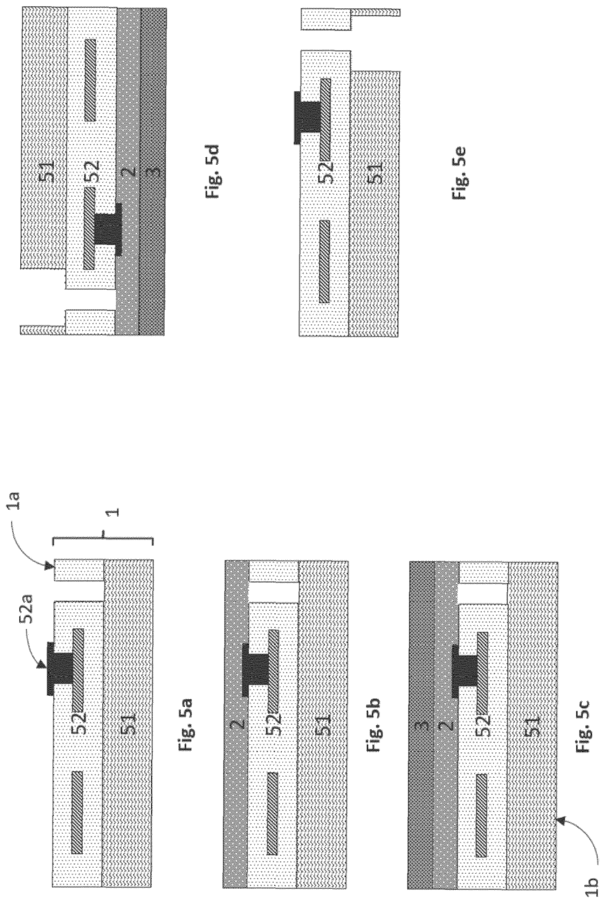

In figure 5a, wafer 1 comprises a stack of semiconductor layers 51, 52 wherein at least one semiconductor layer comprises CMOS circuitry embedded therein. Wafer 1 further comprises a protrusion 52a on the front surface 1a. According to an example embodiment, the protrusion is a conductive via for providing electrical connection from the front surface 1a to the embedded CMOS circuitry. According to an example embodiment, the conductive via is a metal via. According to an example embodiment, the front surface 1a may comprise a cavity.

In figure 5b, the plain protective film 2 is laminated on the front surface 1a of the wafer 1. The temperature and pressure applied during the lamination process make the plain protective film 2 more flexible and eliminate any air entrapment between the front surface 1a of the wafer 1 and the plain protective film 2. The protrusion 52a has a height exceeding the front surface 1a by less than the thickness of the plain protective film 2.

In figure 5c, a layer of temporary bonding material (not shown in the figure) is applied on the plain protective film 2. A rigid carrier 3 is bonded to the plain protective film 2 by the intermediate of the adhesive temporary bonding material layer. The temporary bonding material is not exposed to the front surface 1a of the wafer 1. During any steps of the processing, including the post baking of the lamination process or any later heating process, the adhesive temporary bonding material layer does not form any intimate contact with the wafer 1. Therefore, no contamination of the wafer from the temporary bonding material layer occurs during the whole process.

In figure 5d, the wafer 1 is flipped over so that back surface 1b can be easily processed. A cavity is formed from the back surface 1b of the wafer 1. According to an example embodiment, the wafer 51 can be thinned before the cavity is formed. According to an example embodiment, the cavity from the back surface 1b is extended to a cavity from the front surface 1a of the wafer 1.

In figure 5e, the wafer 1 is flipped over again so that the rigid carrier 3 and the plain protective film can be more easily removed from the front surface 1a of the wafer 1.

**Claims**

1. A temporary wafer bonding process comprising the steps of:

   a. providing a wafer (1) for back processing by

   a.1 laminating a plain protective film (2) on a front surface (1a) of the wafer (1);
   b. providing a rigid carrier (3);
   c. bonding the rigid carrier (3) to the plain protective film (2) by the intermediate of a bonding material layer;
   d. processing a back surface (1b) of the wafer (1);
   e. separating the rigid carrier (3) and the plain protective film (2) from the wafer (1).

2. A process according to claim 1 wherein the step (e) of separating the rigid carrier (3) and the plain protective film (2) from the wafer (1) comprises:

   e.1. separating the rigid carrier (3) from the plain protective film (2); followed by
   e.2. removing the plain protective film (2) from the front surface (1a) of the wafer (1).

3. A process according to any of the preceding claims, wherein the step (e) of separating the rigid carrier (3) and the plain protective film (2) from the wafer (1) comprises wet etching the plain protective film (2).

4. A process according to any of the preceding claims, wherein the step (d) of processing a back surface (1b) of the wafer (1) comprises a heating step of the back surface (1b) above 150 °C.

5. A process according to any of the preceding claims, wherein the wafer (1) is a semiconductor substrate, optionally comprising CMOS circuitry.

6. A process according to any of the preceding claims, wherein the rigid carrier (3) is transparent.

7. A process according to any of the preceding claims, wherein the rigid carrier (3) is a glass carrier.

8. A process according to any of the preceding claims, wherein the front surface of the wafer comprises a cavity, optionally extending to the back surface (1b), before the step (a.1) of laminating a plain protective film (2) on a front surface (1a) of a wafer (1).

9. A process according to claim 8, wherein the cavity has an aspect ratio of at least 1.

10. A process according to any of the preceding claims, wherein the wafer (1) in the step (a) of providing a wafer (1) for back processing comprises a stack of layers (31, 32, 41, 42, 51, 52), and wherein at least one of the layers is formed by wafer bonding.

11. A process according to any of the preceding claims, wherein the plain protective film (2) comprises a polymer, preferably having a glass transition temperature below 100°C.

12. A process according to any of the preceding claims, wherein the plain protective film (2) either is glue-free or comprises a glue layer thinner than 5nm on the surface of the plain protective film that will contact the front surface (1a) of the wafer during step (a.1) of laminating a plain protective film on a front surface of the wafer.

13. A process according to any of the preceding claims, wherein the bonding material layer comprises a photosensitive material.

14. A process according to claim 13 wherein the step (e) of separating the rigid carrier (3) and the plain protective film (2) from the wafer (1) comprises a step of exposing the wafer (1) to UV light.

15. A process according to any of the preceding claims, wherein the step (a.1) of laminating a plain protective film (2) on a front surface (1a) of a wafer (1) is performed at a temperature above 85°C and a pressure above 103 kPa.

a. providing a wafer for back processing

Providing the front surface of the wafer comprises a cavity

and /or

providing a stack of at least two wafers bonded together

a.1 laminating a plain protective film on a front surface of the wafer

b. providing a rigid carrier

c. bonding the rigid carrier to the plain protective film by the intermediate of a bonding material layer

d. processing a back surface of the wafer

annealing of the back surface

e. separating the rigid carrier and the plain protective film from the wafer

e.1. separating the rigid carrier from the plain protective film

e.2. removing the plain protective film from the front surface of the wafer

Fig. 1

a

1a

1

**Fig. 2a**

a.1

2

1

**Fig. 2b**

c

3

2

1b

1

**Fig. 2c**

d

1b

1

2

3

**Fig. 2d**

e

1

**Fig. 2e**

Fig. 3a

Fig. 3b

Fig. 3c

EP 4 350 750 A1

Fig. 4d

Fig. 4e

Fig. 4a

Fig. 4b

Fig. 4c

Fig. 5d

Fig. 5e

Fig. 5a

Fig. 5b

Fig. 5c

Fig. 6c

Fig. 6b

Fig. 6a

Europäisches
Patentamt

European
Patent Office

Office européen
des brevets

# EUROPEAN SEARCH REPORT

**Application Number**

EP 22 19 9670

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/023436 A1 (LIU XIAO [US] ET AL) 28 January 2016 (2016-01-28) * paragraphs [0020] - [0042]; figure 1 * ----- | 1-15 | INV. H01L21/683 |
| X | US 2014/106473 A1 (ANDRY PAUL S [US] ET AL) 17 April 2014 (2014-04-17) * paragraphs [0016], [0030], [0033], [0036] - [0043], [0046], [0051], [0056]; figures 1,2 * ----- | 1-7,11, 13,14 | |

**TECHNICAL FIELDS SEARCHED (IPC)**

H01L

The present search report has been drawn up for all claims

| Place of search | Date of completion of the search | Examiner |
|---|---|---|
| Munich | 28 April 2023 | Diaz Alvarez, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 19 9670

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2023

| Patent document cited in search report | | Publication date | Patent family member(s) | | Publication date |
|---|---|---|---|---|---|
| US 2016023436 | A1 | 28-01-2016 | CN | 106687541 A | 17-05-2017 |
| | | | EP | 3172762 A2 | 31-05-2017 |
| | | | JP | 6591526 B2 | 16-10-2019 |
| | | | JP | 2017530206 A | 12-10-2017 |
| | | | KR | 20170039187 A | 10-04-2017 |
| | | | SG | 11201700478Y A | 27-02-2017 |
| | | | TW | 201609402 A | 16-03-2016 |
| | | | US | 2016023436 A1 | 28-01-2016 |
| | | | WO | 2016014648 A2 | 28-01-2016 |
| US 2014106473 | A1 | 17-04-2014 | CN | 104718605 A | 17-06-2015 |
| | | | GB | 2520905 A | 03-06-2015 |
| | | | JP | 2016500918 A | 14-01-2016 |
| | | | KR | 20150064208 A | 10-06-2015 |
| | | | US | 2014103499 A1 | 17-04-2014 |
| | | | US | 2014106473 A1 | 17-04-2014 |
| | | | WO | 2014058601 A1 | 17-04-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **N. ARAKI et al.** Development of Micrometer-Thick Bonding Material for Wafer-On-Wafer (WOW) Applications. *2018 13th International Microsystems, Packaging, Assembly and Circuits Technology Conference (IMPACT),* 2018, 214-217